# EUROPÄISCHE PATENTSCHRIFT

(11) **EP 3 664 130 B1**
(45) Veröffentlichungstag und Bekanntmachung des Hinweises auf die Patenterteilung: **02.02.2022**
(21) Anmeldenummer: 18210739.1
(22) Anmeldetag: 06.12.2018
(51) Int. Cl.: H01L 21/673, B65D 85/30, B65D 81/127, B65D 1/36, B65D 81/02, B65D 21/02, B65D 81/26

(54) **VERPACKUNGSEINHEIT FÜR EIN SUBSTRAT**
PACKAGING UNIT FOR A SUBSTRATE
UNITÉ D'EMBALLAGE POUR UN SUBSTRAT

(43) Veröffentlichungstag der Anmeldung: 10.06.2020
(73) Patentinhaber: Heraeus Deutschland GmbH & Co. KG, 63450 Hanau (DE)
(72) Erfinder: RICHTER, Hans-Jürgen, 63450 Hanau (DE); WACKER, Richard, 63450 Hanau (DE); PELSHAW, Nadja, 63450 Hanau (DE); LÖWER, Yvonne, 63450 Hanau (DE)
(74) Vertreter: Maiwald Patent- und Rechtsanwaltsgesellschaft mbH

(56) Entgegenhaltungen:
- WO-A1-2007/007941
- WO-A1-2017/139490
- CN-B- 106 742 537
- DE-A1-102004 056 879
- JP-A- 2011 016 557
- JP-A- 2011 148 510
- US-A1- 2003 012 628
- US-A1- 2014 363 916
- US-B1- 6 296 122

## Beschreibung

Die vorliegende Erfindung betrifft eine Verpackungseinheit für ein Substrat, einen Verpackungsstapel mit solchen Verpackungseinheiten und ein Verfahren zur Verpackung eines Substrats.

### Hintergrund der Erfindung

Keramikschaltungsträger sind aufgrund ihrer hohen Wärmeleitfähigkeit, hohen Formstabilität bzw. mechanischen Festigkeit sowie ihrer hohen Isolationsfestigkeit insbesondere im Bereich der Hochleistungselektronik von Interesse.

WO 2017/139490 offenbart einen Substratbehälter, der eine Basis und eine Abdeckung umfasst.

WO 2007/007941 offenbart eine Vorrichtung mit einer Verstärkungseinrichtung zum horizontalen Verpacken von Dünnfilmanzeigetafeln.

US 2014/363916 offenbart eine transportable Prozessbox zur Verarbeitung von einseitig beschichteten Substraten.

DE 10 2004 056879 offenbart ein Verfahren zum Herstellen von doppelseitig metallisierten Metall-Keramik-Substraten.

US 6 296 122 offenbart Abschnitte zum Bestimmen, wann eine Mehrzahl von Verpackungsschalen gestapelt ist.

JP 2011 016557 offenbart eine Ablage zum Verpacken einer Komponente, mit der die Richtung der Ablage auf einen Blick erkannt werden kann.

JP 2011 148510 offenbart einen Aufbewahrungsbehälter, mit dem verhindert werden kann, dass ein plattenförmiger Gegenstand beschädigt wird.

CN 106 742 537 offenbart eine Ablage zum Halten von Flüssigkristallanzeigetafeln.

US 2003/012628 offenbart einen verriegelbaren Filmrahmenträger, welcher zentrale und periphere Abschnitte zum sicheren Aufbewahren eines Filmrahmens aufweist.

DE 10 2010 018 668 B4 offenbart eine Verpackungseinheit aus einer Verpackung für Metall-Keramik-Substrate und mehrere Metall-Keramik-Substrate, jeweils bestehend aus einer Keramikschicht und aus auf wenigstens einer Oberflächenseite der Keramikschicht gebildeten Einzelmetallisierung und zwischen diesen verlaufenden Sollbruchlinien.

DE 10 2012 106 087 B4 offenbart eine Verpackungseinheit für Substrate, insbesondere für Metallkeramiksubstrate, bestehend aus einer Verpackung mit einem aus einem Flachmaterial hergestellten Verpackungsunterteil und einer von einer Vertiefung in einem oberen Bodenabschnitt des Verpackungsunterteils gebildeten Aufnahme für mehrere oder wenigstens einen Substratstapel oder Teilstapel.

Besonders für empfindliche Substrate und insbesondere Substrate mit empfindlichen Oberflächen oder Oberflächenabschnitten können diese Verpackungen aber noch verbessert werden.

### Zusammenfassung der Erfindung

Es ist daher eine Aufgabe der vorliegenden Erfindung, eine Verpackungseinheit für Substrate bereitzustellen, mit welcher auch empfindliche Substrate sicher verpackt werden können.

Diese Aufgabe wird durch eine Verpackungseinheit für ein Substrat, einen Verpackungsstapel mit einer Vielzahl solcher Verpackungseinheiten und ein Verfahren zur Verpackung eines Substrats nach den unabhängigen Ansprüchen gelöst. Vorteilhafte Ausführungsformen und Weiterbildungen sind den Unteransprüchen und der nachfolgenden Beschreibung zu entnehmen.

Die Verpackungseinheit für ein Substrat umfasst eine Schale, ein Substrat und einen Deckel. Das Substrat ist in die Schale eingelegt. Auf eine Oberfläche des Substrats ist ein Metalldepot aufgebracht und auf dem Metalldepot ist ein Klebepunkt angeordnet. Der Deckel ist auf die Schale aufgesetzt und weist mindestens einen Vorsprung auf, der das Substrat außerhalb des Klebepunkts berührt und das Substrat in einer Richtung senkrecht zur Oberfläche des Substrats fixiert.

Das Substrat kann ein beliebiges Trägermaterial sein, welches zum Beispiel nicht sofort fertig verarbeitet wird und daher zunächst zuverlässig aufbewahrt werden muss. Das Substrat kann flächenförmig ausgebildet sein und eine flache ebene Struktur aufweisen. Beispielsweise kann das Substrat in der Halbleitertechnik ein Ausgangsmaterial für eine Fertigung von Elektronikmodulen sein.

Das Substrat weist auf seiner Oberfläche ein sogenanntes Metalldepot auf. Das Metalldepot, in anderen Worten ein Metallvorrat, kann je nach Einsatzzweck ein Metall oder mehrere verschiedene Metalle in bestimmten Mischungsverhältnissen umfassen oder daraus bestehen. Das Metalldepot kann beispielsweise für eine dauerhafte, feste Verbindung von Bauteilen geeignet sein, beispielsweise indem es sich als Schmelze mit der Oberfläche von Bauteilen verbindet bzw. legiert und nach Abkühlung erstarrt oder indem es sich im Sinne eines Sintermaterials ohne zu schmelzen mit der Oberfläche von Bauteilen verbindet. Größe und Dicke des Metalldepots können je nach Einsatzzweck variiert werden.

Auf dem Metalldepot ist ein Klebepunkt angeordnet. Der Klebepunkt kann dazu dienen, ein zum Beispiel elektronisches Bauteil auf dem Substrat zu fixieren, um einen darauffolgenden Löt- oder Sintervorgang zwischen dem elektronischen Bauteil und dem Substrat zu erleichtern. Der Klebepunkt kann beim Verlöten oder beim Sintern des elektronischen Bauteils mit dem Substrat unzersetzt verdampfen und/oder sich unter Zersetzung verflüchtigen, sodass der Klebepunkt keine oder keine störenden Rückstände hinterlässt.

Die Verpackungseinheit weist eine Schale auf. Die Schale kann wannenförmig ausgebildet sein, um das Substrat im Innenraum der Schale aufzunehmen. Auf die Schale ist ein Deckel aufgesetzt, der mindestens einen Vorsprung in Richtung des Innenraums der Schale umfasst. Der Vorsprung kann beispielsweise punktförmig oder in Form einer rechteckigen Vertiefung geformt sein. Der Vorsprung kann sich vertikal bzw. senkrecht an der Oberfläche des Substrats abstützen, um das Substrat in der Schale festzuhalten. Dabei ist es wichtig, dass der Vorsprung das Substrat außerhalb des Klebepunkts berührt. In anderen Worten, der Vorsprung berührt den Klebepunkt nicht, weder seitlich noch an der Oberseite des Klebepunkts. Auf diese Weise wird erreicht, dass der Klebepunkt nicht verschmiert wird. Der Vorsprung kann auch so auf das Substrat aufgelegt sein, dass er das Substrat auch nur außerhalb des Metalldepots berührt. Bevorzugt berührt der Vorsprung das Metalldepot weder seitlich noch an der Oberseite des Metalldepots. Der Vorsprung kann sich jedoch an der Oberfläche des Substrats abstützen, sodass der Vorsprung die Oberseite des Substrats, die dem Deckel zugewandt ist, senkrecht bzw. in vertikaler Richtung fixiert. Daher kann eine Höhe des Vorsprungs von einer Oberfläche des Deckels in Richtung des Innenraums der Schale je nach Anzahl bzw. Höhe des oder der eingelegten Substrate variieren.

Der Vorteil der erfindungsgemäßen Verpackungseinheit liegt darin, dass auch empfindliche Substrate sicher verpackt und insbesondere platzsparend gestapelt werden können, ohne den Klebepunkt auf dem Metalldepot zu berühren. Die erfindungsgemäße Verpackungseinheit ermöglicht, dass das Metalldepot und der Klebepunkt unmittelbar nach dem Herstellen des Substrats durch einen Hersteller oder Weiterverarbeiter des Substrats auf das Substrat aufgebracht werden können und das Substrat mit Metalldepot und Klebepunkt problemlos an einen Weiterverarbeiter oder einen Anwender verschickt werden kann. Auf diese Weise können Weiterverarbeiter oder Anwender des mit Metalldepot und Klebepunkt versehenen Substrats ein weiteres Bauteil direkt auf den Klebepunkt des Substrates aufbringen und beispielsweise mittels eines Löt- oder Sinterverfahrens das Bauteil direkt (ohne eine Vorarbeit zum Fixieren des Bauteils) befestigen. Dieses sogenannte Vorapplizieren des Metalldepots und des Klebepunkts ermöglicht, dass ein weiteres Bauteil kostengünstig auf dem Substrat befestigt werden kann. Bislang werden die Substrate generell ohne vorapplizierte Metall- oder Lotdepots hergestellt und vertrieben. Daher ist es nicht erforderlich, die Substrate anders als durch durchgängige Folien voneinander zu separieren. Im Falle eines Substrats mit vorappliziertem Metalldepot jedoch wird ein Klebepunkt auf das Substrat aufgebracht, der während des Verpackens und Versands der Teile nicht verschmiert oder berührt werden darf. Die erfindungsgemäße Schale und der erfindungsgemäße Deckel mit mindestens einem Vorsprung ermöglichen, dass die Substrate platzsparend gestapelt, aufbewahrt und/oder transportiert werden können, ohne den Klebepunkt zu berühren.

In einer Ausführungsform sind mindestens zwei Substrate als Stapel in die Schale eingelegt, und ein Abstandshalter ist so zwischen die Substrate eingelegt, dass der Abstandshalter das Substrat nur außerhalb des Klebepunkts berührt.

Mindestens zwei Substrate, vorzugsweise mehrere Substrate, können in vertikaler Richtung aufeinandergestapelt und als ein Substratstapel in die Schale eingelegt werden. Dabei ist es wichtig, dass der Klebepunkt jedes Substrats nicht berührt bzw. verschmiert wird. Der Abstandshalter kann zwischen zwei aufeinanderfolgenden Substraten positioniert werden, um einen Kontakt zwischen den Substraten zu vermeiden. In anderen Worten, der Abstandshalter kann auf ein erstes Substrat aufgelegt sein und ein zweites Substrat kann auf den Abstandshalter aufgelegt sein. Der Abstandshalter kann so auf das erste Substrat aufgelegt sein, dass der Abstandshalter das erste Substrat nur außerhalb des Klebepunkts berührt. Bevorzugt berührt der Abstandshalter das Metalldepot weder seitlich noch an der Oberseite des Metalldepots.

Der Abstandshalter kann zumindest einen Ausschnitt aufweisen, sodass der Abstandshalter auf die Oberfläche des ersten Substrats aufgelegt werden kann, ohne den Klebepunkt zu berühren. Auf den Abstandshalter kann das zweite Substrat aufgelegt werden, wobei der Abstandshalter eine Unterseite des zweiten Substrats berührt. Die "Unterseite" kann eine Oberfläche des Substrats sein, auf welcher weder Metalldepot noch Klebepunkt platziert wird. Im Gegensatz dazu kann eine "Oberseite" eine Oberfläche des Substrats sein, auf welcher das Metalldepot und der Klebepunkt appliziert sind.

Der Abstandshalter kann kleiner als oder gleich groß wie das Substrat sein. In anderen Worten, die äußeren Abmessungen des Abstandshalters können maximal so groß wie die äußeren Abmessungen des Substrats sein. Noch präziser, ein Außenumfang oder eine Außenkontur des Abstandshalters kann kleiner als oder genauso groß sein wie ein Außenumfang oder eine Außenkontur des Substrats.

Der Abstandshalter bzw. der Ausschnitt des Abstandshalters kann dazu beitragen, dass die Substrate gestapelt, aufbewahrt und/oder transportiert werden können, ohne den Klebepunkt zu berühren. Daher kann ein Abstandshalter auf eine oberste Schicht des Substratstapels aufgebracht werden, um eine Berührung des Klebepunkts bzw. Metalldepots durch den Deckel zu vermeiden.

In einer Ausführungsform kann der Abstandshalter stegförmig sein. In anderen Worten, der Abstandshalter kann zumindest einen Ausschnitt, bevorzugt eine Vielzahl von Ausschnitten und Zwischenbrücken bzw. Führungsleisten aufweisen, die die Ausschnitte verbinden. Die Ausschnitte können eine identische Form aufweisen und die Form kann rechteckig, rund, oval oder ähnlich ausgebildet sein. Jeder der Ausschnitte kann auch unterschiedliche Formen aufweisen. Die Ausschnitte können dazu dienen, dass der Klebepunkt auf dem Metalldepot trotz des Stapelns von Substraten und Abstandshaltern unberührt bleibt und somit nicht verschmiert wird. Der Abstandshalter kann aus Kunststoff oder Karton hergestellt sein. Der Abstandshalter kann aus Rollenware hergestellt werden. Auf diese Weise kann der Abstandshalter kostengünstig und einfach hergestellt werden.

In einer Ausführungsform umfasst die Schale einen Boden und eine umlaufende Wand, welche in Richtung des Bodens eine geringere Außenabmessung aufweist als an ihrem freien Ende. In anderen Worten die umlaufende Wand der ersten Schale kann kegelförmig ausgebildet sein, sodass sich die Wand in Richtung des freien Endes der Schale aufweitet.

Der Boden der Schale kann beispielsweise eine rechteckige Form aufweisen, um ein Substrat aufzunehmen, welches im Wesentlichen rechteckig ausgebildet ist. Die umlaufende Wand der Schale kann senkrecht zum Boden der Schale stehen oder sich allmählich vom Boden in Richtung des freien Endes der Schale aufweiten. Auf diese Weise kann die Schale einen seitlichen Spielraum bereitstellen, in dem sich z.B. ein Greifmechanismus frei bewegen kann, sodass das Substrat bzw. der Substratstapel leicht in die Schale eingelegt oder aus der Schale herausgenommen werden kann. Im Gegensatz dazu kann der Boden der Schale eine gleiche Außenabmessung wie das Substrat haben, um das Substrat am Boden festzuhalten. Die Schale kann aus Kunststoff oder Karton hergestellt sein. Auf diese Weise können die Schalen kostengünstig, leicht und einfach hergestellt werden. Die Schalenmaterialien können dabei durchsichtig ausgebildet sein.

In einer Ausführungsform weist der Deckel mindestens ein Zentrierelement zum Befestigen des Deckels auf der Schale auf. Das Zentrierelement kann beispielsweise eine Schnappverbindung sein. Der Begriff Schnappverbindung kann so verstanden werden, dass zwei Elemente mit einfachem formschlüssigem Fügen lösbar kombiniert werden. In anderen Worten, kann die Schale eine Zentrierelementaufnahme umfassen, die sich elastisch mit dem Zentrierelement des Deckels verformen kann, um ineinander greifen zu können. Der Deckel kann beispielsweise auf seiner Oberfläche mindestens eine Vorwölbung in Richtung des Innenraums der Schale aufweisen, die mit einer auf der Oberseite der Schale versehenen Aussparung zusammengefügt werden kann, um den Deckel in einer vorbestimmten Position auf der Schale zu befestigen.

In einer Ausführungsform sind die Schale und der Deckel unterschiedlich geformt. Der Deckel kann beispielsweise wannenförmig eingerichtet sein, um die Schale formschlüssig zuzudecken. In anderen Worten, der Deckel kann einen vertieften Boden mit einer umlaufenden Wand umfassen, wobei der Boden zumindest einen Vorsprung zum Fixieren des Substrats aufweist. Somit kann die umlaufende Wand des Deckels an der umlaufenden Wand der Schale anliegen. Eine Höhe der umlaufenden Wand des Deckels kann jedoch geringer als eine Höhe der Schale sein, sodass im Innenraum der Schale ausreichend Platz für ein Substrat bzw. einen Substratstapel vorhanden ist.

In einer Ausführungsform sind die Schale und der Deckel einstückig ausgebildet. Die Schale und der Deckel können beispielsweise durch Spritzgießen, Extrusion, Spritzblasformen oder ähnliches hergestellt werden. Die Schale und der Deckel können einteilig, d.h. gemeinsam und zusammen hergestellt sein oder zunächst separat hergestellt und durch Schweißen oder Kleben dauerhaft einteilig miteinander verbunden sein. Der Deckel kann beispielsweise ein Klappdeckel mit einem Filmscharnier sein. Auf diese Weise kann die Schale unmittelbar nach dem Einlegen des Substrats oder Substratstapels in die Schale verschlossen werden.

In einer Ausführungsform können mindestens zwei Substrate bzw. Substratstapel nebeneinander in die Schale eingelegt sein und diese durch mindestens ein Trennelement voneinander beabstandet sein. Das Trennelement kann von der umlaufenden Wand der Schale in Richtung des Innenraums der Schale hervorstehen, um den Innenraum der Schale mindestens in zwei Teile zu unterteilen. Das Trennelement kann aber auch ein separates Element sein, das beispielsweise in die Schale eingelegt und durch die umlaufende Wand der Schale eingeklemmt werden kann. Auf diese Weise können mehrere Substratstapel platzsparend aufbewahrt und/oder transportiert werden.

In einer Ausführungsform ist das Substrat ein Metallkeramiksubstrat und umfasst eine Keramikschicht und mindestens eine Metallisierungsschicht, wobei das Metalldepot auf die Metallisierungsschicht aufgebracht ist. In einer Ausführungsform umfasst das Metallkeramiksubstrat die Keramikschicht und zwei Metallisierungsschichten, wobei das Metalldepot auf eine der Metallisierungsschichten aufgebracht ist. In einer Ausführungsform umfasst das Metallkeramiksubstrat eine Keramikschicht und zwei Metallisierungsschichten und beide Metallisierungsschichten weisen eine außenliegende Oberfläche auf, auf die ein Metalldepot aufgebracht ist.

Der Begriff "Metallkeramiksubstrat" kann so verstanden werden, dass das Substrat aus Keramik hergestellt und durch verschiedene Verfahren wie z.B. Direct-Copper-Bonding (üblicherweise als DCB-Verfahren bezeichnet), Direct-Aluminium-Bonding (üblicherweise als DAB-Verfahren bezeichnet) oder Active-Metal-Brazing (üblicherweise als AMB-Verfahren bezeichnet) metallisiert werden kann. Geeignete Materialien für das Keramiksubstrat sind beispielsweise ein Oxid, ein Nitrid, ein Carbid, oder ein Gemisch oder Komposit aus zumindest zweien dieser Materialien, insbesondere ggf. dotierte Aluminiumoxid- oder Siliziumnitrid-Keramik. Das nach der Metallisierung des Keramiksubstrats erhaltene Verbundmaterial wird auch als Metall-Keramik-Substrat oder Metall-Keramik-Verbund bezeichnet. Sofern es beispielsweise durch ein DCB-Verfahren hergestellt wurde, wird häufig auch die Bezeichnung "DCB-Substrat" verwendet.

Das Substrat kann ein Direct Copper Bonding (DCB) oder ein Direct Aluminium Bonding (DAB) Substrat sein, welches eine gute elektrische und thermische Verbindung elektronischer Bauteile und Chips über Kupfer bzw. Aluminium ermöglicht.

In einer Ausführungsform ist der Klebepunkt gestaltet, um ein elektronisches Bauteil auf dem Substrat zu fixieren, und der Klebepunkt ist bei Raumtemperatur verschmierbar. Verschmierbar bedeutet, dass der Klebepunkt nach dem Applizieren auf den Metalldepots beispielsweise angetrocknet sein kann, jedoch an der Luft nicht fest oder hart wird, sondern klebrig oder schmierig bleibt. Der verschmierbare Klebepunkt ist weder vollständig fest noch vollständig flüssig. Er kann eine bestimmte Viskosität aufweisen, sodass sich beispielsweise ein auf den Klebepunkt aufgebrachtes weiteres Bauteil selbst bei einer zum Beispiel 90° schrägen Lage des Substrats nicht selbstständig bewegt oder selbstständig rutschen kann.

Das Metallkeramiksubstrat kann für eine elektronische Anwendung geeignet sein, bei der ein elektronisches Bauteil beispielsweise ein Chip, ein Schalter, ein Beleuchtungselement, ein Kondensator, ein Widerstand oder ähnliches aufgebracht wird.

Das Substrat kann aber auch auf beiden Seiten jeweils ein Metalldepot und auch einen Klebepunkt umfassen. Das bedeutet, dass das Substrat sowohl auf seiner Oberseite als auch auf seiner Unterseite ein Metalldepot und auch einen Klebepunkt aufweisen kann. Die Schale und der Abstandshalter können so eingerichtet sein, dass der in vertikaler Richtung nach oben gerichtete Klebepunkt nicht mit einer Innenseite des Deckels oder einem daraufgelegten Substrat und der in vertikaler Richtung nach unten gerichtete Klebepunkt nicht mit dem Boden der Schale oder einem daruntergelegten Substrat in Berührung kommen.

In einer Ausführungsform umfasst das Metalldepot ein lötbares oder sinterbares Metall oder eine lötbare oder sinterbare Legierung. Das Metalldepot kann auch als ein Lot- oder Sinterdepot verstanden werden und ein bestimmtes Volumen aufweisen oder eine Metall-/Legierungsschicht sein. Das Metalldepot kann im Falle eines lötbaren Metalls durch Löten, beispielsweise durch ein Vakuumlöten in einer aktiven Atmosphäre mit Ameisensäureaktivierung, auf das Metallkeramiksubstrat aufgebracht werden. Im Falle eines sinterbaren Metalls kann das Metalldepot durch Sintern oder Ansintern auf das Metallkeramiksubstrat aufgebracht werden. Das Metalldepot kann auf dem Metallkeramiksubstrat in einem definierten Volumen, an einer definierten Position und mit einer definierten Form appliziert werden. Auf diese Weise kann das Metallkeramiksubstrat ohne einen Metallpastendruck und/oder einen Reinigungsvorgang weiterverarbeitet werden. Dies ermöglicht, dass ein weiteres Bauteil, beispielsweise ein Chip, ein Schalter, ein Beleuchtungselement, ein Kondensator, ein Widerstand oder ähnliches auf das Substrat bzw. Metalldepot vereinfacht aufgebracht und dort beispielsweise ohne Verwendung von Hilfsstoffen wie beispielsweise Flussmitteln, Reinigungsmitteln und ähnlichem befestigt werden kann.

In einer Ausführungsform umfasst das Substrat eine Vielzahl von nebeneinander angeordneten Einzelsubstraten. Das Substrat kann in Form eines Einzelsubstrats vorliegen. Alternativ ist es auch möglich, dass das Substrat eine oder mehrere (bevorzugt geradlinig verlaufende) Sollbruchlinien aufweist, die das Substrat in zwei oder mehr Bereiche unterteilen. Der Abstandshalter kann zeilenförmig bzw. rasterförmig zwischen den Einzelsubstraten verlaufen.

In einer Ausführungsform weist die Schale ein Trockenmittel zum Beispiel zwischen dem Boden der Schale und dem Substrat zur trockenen Aufbewahrung des Substrats auf. Das Trockenmittel kann verwendet werden, um der Schale Feuchtigkeit zu entziehen und/oder das Substrat vor Oxidation zu schützen. Das Trockenmittel kann beispielsweise Silicagel, Zeolithe, Aluminiumoxid, Kaliumcarbonat oder ähnliches sein. Die Schale kann im Boden eine Vertiefung zum Einlegen des Trockenmittels umfassen. Die Tiefe der Vertiefung kann so eingerichtet sein, dass das eingelegte Trockenmittel die Unterseite des Substrats nicht berührt.

Die vorliegende Erfindung umfasst weiterhin einen Verpackungsstapel, welcher eine Vielzahl von aufeinandergestapelten Verpackungseinheiten umfasst. Durch eine relativ flache Konfiguration des Substrats und des Abstandshalters kann es möglich sein, dass eine Vielzahl von Substraten und Abstandshaltern platzsparend aufeinandergestapelt werden können. Die beispielsweise rasterförmigen Abstandshalter können ermöglichen, dass die Klebepunkte auf den Metalldepots trotz des Stapelns von mehreren Substraten und Abstandshaltern berührungsfrei bleiben. Der Verpackungsstapel kann je nach Einsatzzweck und Lagerkapazität eine beliebige Anzahl von Verpackungseinheiten und damit eine beliebige Anzahl von Substraten, Abstandshaltern und Schalen mit Deckel aufweisen.

In einer Ausführungsform ist zwischen den Verpackungseinheiten ein Dämpfungselement zum Abfedern eines Stoßes eingelegt. Das Dämpfungselement kann aus einem Material, das einen mechanischen Stoß absorbieren kann, hergestellt werden. Das Material kann beispielsweise ein Schaumstoff, ein Papier oder ein Gummi oder ähnliches sein. Das Dämpfungselement kann z.B. blockförmig oder wellenförmig geformt sein. Somit kann der Verpackungsstapel kompakter, platzsparender und sicherer gestapelt werden.

Die vorliegende Erfindung umfasst weiterhin ein Verfahren zur Verpackung eines Substrats. Das Verfahren umfasst die folgenden Schritte:
- Bereitstellen einer Schale,
- Einlegen eines Substrats in die Schale, und
- Aufsetzen eines Deckels auf die Schale,

Auf eine Oberfläche des Substrats ist ein Metalldepot aufgebracht und auf dem Metalldepot ist ein Klebepunkt angeordnet. Der Deckel weist mindestens einen Vorsprung auf, der das Substrat außerhalb des Klebepunkts berührt und das Substrat in einer Richtung senkrecht zur Oberfläche des Substrats fixiert.

In einer Ausführungsform umfasst das Verfahren weiterhin die Schritte:
- Einlegen eines Abstandshalters auf das Substrat in der Schale, und
- Einlegen eines weiteren Substrats auf den Abstandshalter,

Der Abstandshalter ist so zwischen die Substrate eingelegt, dass er das Substrat nur außerhalb des Klebepunkts berührt.

Weitere Merkmale, Vorteile und Anwendungsmöglichkeiten der vorliegenden Erfindung ergeben sich aus der nachfolgenden Beschreibung, den Ausführungsbeispielen und den

Figuren. Alle beschriebenen und/oder bildlich dargestellten Merkmale können unabhängig von ihrer Darstellung in einzelnen Ansprüchen, Figuren, Sätzen oder Absätzen miteinander kombiniert werden. In den Figuren stehen gleiche Bezugszeichen für gleiche oder ähnliche Objekte.

### Kurze Beschreibung der Figuren

Figur 1 zeigt eine Verpackungseinheit gemäß einer Ausführungsform.
Figur 2 zeigt eine Verpackungseinheit gemäß einer Ausführungsform.
Figur 3 zeigt eine Schale gemäß einer Ausführungsform.
Figur 4 zeigt einen Deckel gemäß einer Ausführungsform.
Figur 5 zeigt eine Verpackungseinheit gemäß einer Ausführungsform.
Figur 6 zeigt eine Verpackungseinheit gemäß einer Ausführungsform.
Figur 7 zeigt eine Verpackungseinheit gemäß einer weiteren Ausführungsform.
Figur 8 zeigt einen Verpackungsstapel gemäß einer Ausführungsform.
Figur 9 zeigt ein Metallkeramiksubstratstapel gemäß einer Ausführungsform.
Figur 10 zeigt ein Metallkeramiksubstrat gemäß einer Ausführungsform.

### Detaillierte Beschreibung der Ausführungsbeispiele

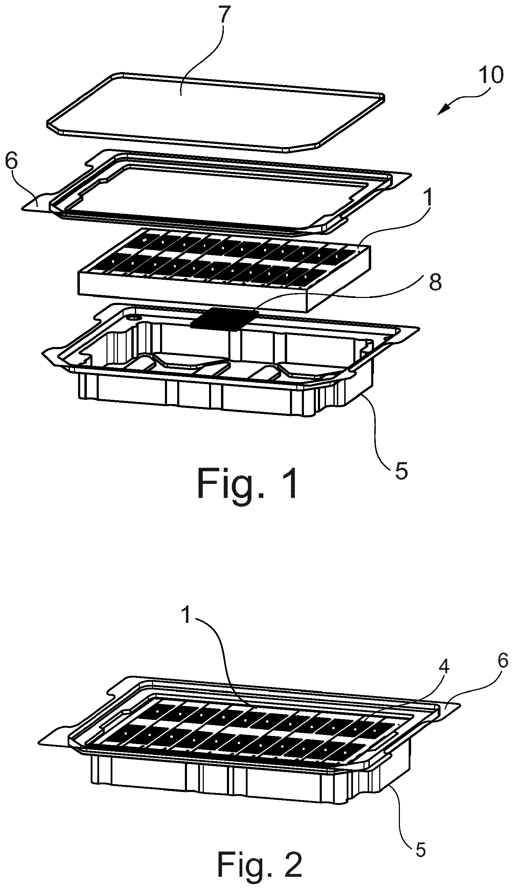

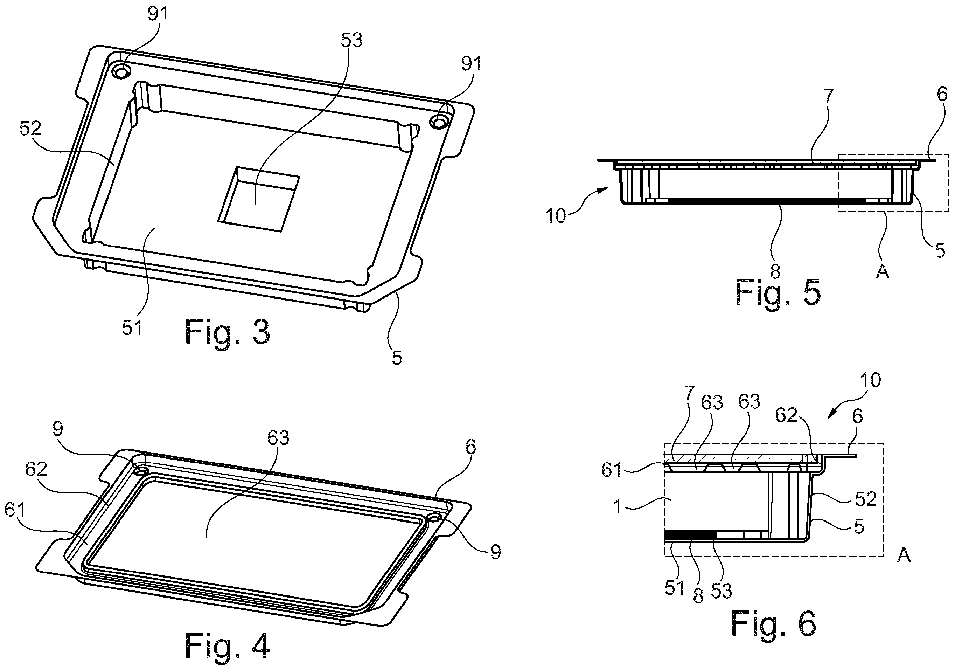

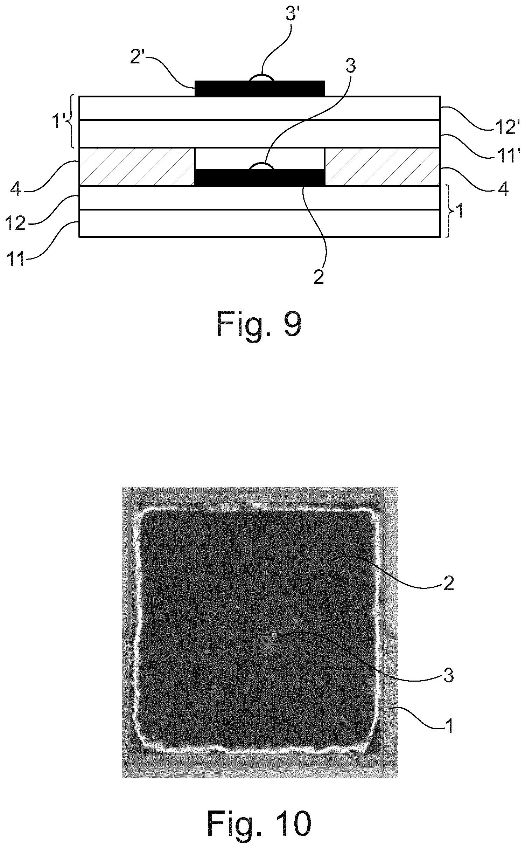

Figur 1 und Figur 2 zeigen eine Verpackungseinheit 10 für ein Metallkeramiksubstrat 1. Die Verpackungseinheit 10 umfasst eine Schale 5, ein Substrat 1 und einen Deckel 6. Das Substrat 1 kann durch ein Direct Copper Bonding (DCB) Verfahren oder Direct Aluminium Bonding (DAB) Verfahren hergestellt werden und eine Vielzahl von nebeneinander angeordneten Einzelsubstraten umfassen (in Figur 2). Das Substrat 1 ist in die Schale 5 eingelegt. Auf eine Oberfläche des Substrats 1 ist ein Metalldepot 2 aufgebracht und auf dem Metalldepot 2 ist ein Klebepunkt 3 angeordnet (in Figur 10). Der Deckel 6 ist auf die Schale 5 aufgesetzt und weist mindestens einen Vorsprung 63 auf (in Figur 6), der das Substrat 1 außerhalb des Klebepunkts 3 berührt und das Substrat 1 in einer Richtung senkrecht zur Oberfläche des Substrats 1 fixiert.

Wie auch in Figur 9 gezeigt, weist das Metallkeramiksubstrat 1, 1' mindestens eine Keramikschicht 11, 11' und eine Metallisierungsschicht 12, 12' auf. Das Metallkeramiksubstrat 1, 1' weist vorzugsweise insgesamt zwei Metallisierungsschichten auf, nämlich die Metallisierungsschicht 12, 12' und eine nicht gezeigte weitere Metallisierungsschicht auf der anderen Seite der Keramikschicht 11, 11'. Auf eine Oberseite der Metallisierungsschicht 12, 12' ist ein Metalldepot 2, 2' aufgebracht und auf dem Metalldepot 2, 2' ist ein Klebepunkt 3, 3' angeordnet. Das Metalldepot 2, 2' umfasst ein lötbares oder sinterbares Metall oder eine lötbare oder sinterbare Legierung. Der Klebepunkt 3, 3' ist bei Raumtemperatur bzw. in Luft klebrig und verschmierbar. Auf den Klebepunkt 3, 3' kann ein elektronisches Bauteil beispielsweise ein Chip, Leuchtmittel, Widerstand, Kondensator etc. aufgebracht werden.

Die Schale 5 und der Deckel 6 können einstückig aus Kunststoff oder Karton hergestellt werden (nicht gezeigt), sie sind jedoch unterschiedlich geformt. Wie auch in Figur 3 gezeigt, umfasst die Schale 5 einen Boden 51 und eine umlaufende Wand 52. Die umlaufende Wand 52 erstreckt sich vom Boden 51 bis in eine Wandhöhe, in der mindestens ein Substrat 1 vorzugsweise ein Substratstapel umschlossen wird. Die umlaufende Wand 52 weist in Richtung des Bodens 51 eine geringere Außenabmessung als an ihrem freien Ende auf.

Der Substratstapel kann mindestens zwei Substrate 1, 1' umfassen, wobei ein Abstandshalter 4 so zwischen die Substrate 1, 1' eingelegt ist, dass der Abstandshalter 4 das Substrat 1 nur außerhalb des Klebepunkts berührt (in Figur 9). Die Substrate 1, 1' umfassen jeweils ein Metalldepot 2, 2' und auf den beiden Metalldepots 2, 2' ist je ein Klebepunkt 3, 3' angeordnet. Der Abstandshalter 4 ist stegförmig oder rasterförmig ausgebildet und so auf das erste Substrat 1 aufgelegt, dass der Abstandshalter 4 das erste Substrat 1 nur außerhalb des Klebepunkts 3 berührt. Der Abstandshalter 4 kann aus aufrollbarem Kunststoff oder Karton hergestellt werden. Eine Dicke bzw. Höhe des Abstandshalters 4 kann zwischen 200 und 1000 µm, bevorzugt zwischen 300 und 800 µm betragen, sodass eine Untergrenze der Dicke des Abstandshalters 4 eine Summe von Metalldepot 2, Klebepunkt 3 und ggf. Sicherheitsabstand nicht unterschreitet. Die Obergrenze der Dicke des Abstandshalters 4 kann ferner so ausgelegt werden, dass ein Ausgangsmaterial für den Abstandshalter 4 aufgerollt werden kann. Wenn zumindest ein Substrat 1, 1' eine Vielzahl von nebeneinander angeordneten Einzelsubstraten umfasst, umrandet der Abstandshalter 4 die Einzelsubstrate, sodass die Klebepunkte 3 nicht berührt werden (in Figur 2).

Wie in Figur 3 gezeigt, weist die Schale 5 weiterhin eine Vertiefung 53 auf, in welche ein Trockenmittel 8 zwischen dem Boden 51 der Schale 5 und dem Substrat 1 zur trockenen Aufbewahrung des Substrats 1 eingelegt wird. Eine Höhe der Vertiefung 53 kann so eingerichtet sein, dass das eingelegte Trockenmittel 8 eine Unterseite des Substrats 1 nicht berührt. Das Trockenmittel 8 kann verwendet werden, um der Schale 5 Feuchtigkeit zu entziehen und/oder das Substrat 1 vor Korrosion zu schützen.

Figur 4 zeigt den Deckel 6, der auf die Schale 5 aufgesetzt wird, um die Schale 5 dicht zu verschließen. Der Deckel 6 kann wannenförmig eingerichtet sein. In anderen Worten, der Deckel 6 kann einen vertieften Boden 61 mit einer umlaufenden Wand 62 umfassen. Auf diese Weise kann die umlaufende Wand 62 des Deckels 6 an der umlaufenden Wand 52 der Schale 5 anliegen. Der Boden 61 weist zumindest einen Vorsprung 63 zum Fixieren des Substrats oder Substratstapels 1 auf. Eine Höhe des Vorsprungs 63 des Deckels 6 kann jedoch geringer als die Höhe der Schale 5 sein, sodass im Innenraum der Schale 5 ausreichend Platz für ein Substrat 1, vorzugsweise für einen Substratstapel vorhanden ist. Der Deckel 6 weist weiterhin mindestens ein Zentrierelement 9 auf, das vorzugsweise im Boden 61 des Deckels 6, jedoch außerhalb des Vorsprungs 63, ausgebildet ist, um den Deckel 6 auf der Schale 5 zu befestigen. Um das Zentrierelement 9 des Deckels 6 aufzunehmen, kann die Schale 5 eine entsprechende Zentrierelementaufnahme 91 umfassen (in Figur 3).

Figur 5 zeigt eine seitliche Ansicht der Verpackungseinheit 1 und Figur 6 zeigt eine vergrößerte Darstellung der Figur 5, in der eine Anordnung des Substrats 1, der Schale 5 mit dem Trockenmittel 8 und des Deckels 6 abgebildet ist. Wie in Figur 5 gezeigt, wird das Substrat 1 durch die Vorsprünge 63 des Deckels 6 fixiert.

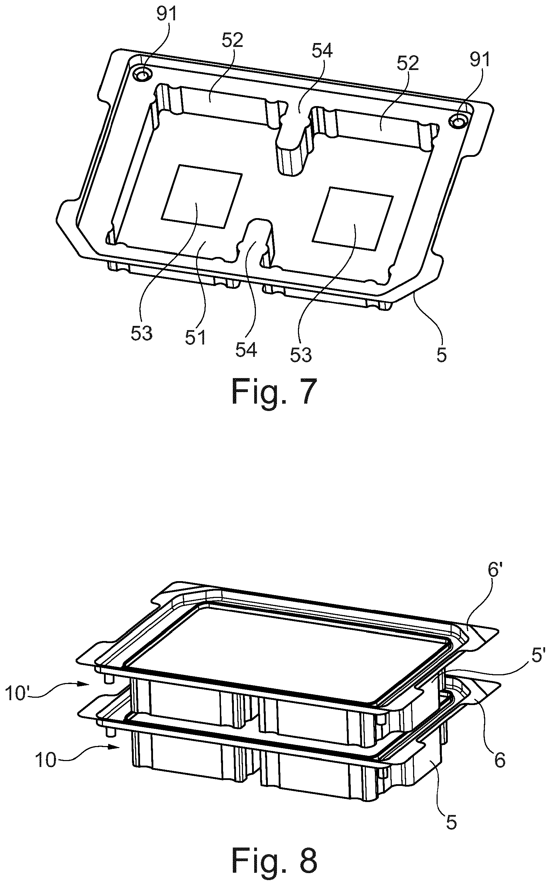

Figur 7 zeigt eine Schale 5, die ermöglicht, dass mindestens zwei Substrate bzw. Substratstapel nebeneinander in die Schale eingelegt werden können. Die Schale umfasst mindestens ein Trennelement 54, das zum Beabstanden der Substrate bzw. Substratstapel eingerichtet ist. Das Trennelement 54 kann von der umlaufenden Wand 52 der Schale 5 in Richtung des Innenraums der Schale 5 hervorstehen, um den Innenraum der Schale 5 mindestens in zwei Teile zu unterteilen.

Figur 8 zeigt einen Verpackungsstapel, der eine Vielzahl von aufeinandergestapelten Verpackungseinheiten 10 umfasst. Zwischen den Verpackungseinheiten 10 kann ein Dämpfungselement 7 eingelegt sein, das zum Abfedern eines Stoßes eingerichtet ist. Das Dämpfungselement 7 kann z.B. blockförmig oder wellenförmig geformt sein und beispielsweise aus Schaumstoff, Papier oder Gummi hergestellt sein, um einen mechanischen Stoß zu absorbieren. Jeder unterteilte Bereich in der Schale kann in seinem Boden 51 eine Vertiefung 53 zum Einlegen des Trockenmittels 8 umfassen.

Ergänzend sei darauf hingewiesen, dass "umfassend" und "aufweisend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkungen anzusehen.

Der Schutzbereich des europäischen Patents und der europäischen Patentanmeldung wird durch die Patentansprüche bestimmt. Die Beschreibung und die Zeichnungen sind jedoch zur Auslegung der Patentansprüche heranzuziehen.

## Patentansprüche

1. Eine Verpackungseinheit (10) für ein Substrat (1), umfassend:
- eine Schale (5),
- ein Substrat (1), und
- einen Deckel (6),
wobei das Substrat (1) in die Schale (5) eingelegt ist,
wobei auf eine Oberfläche des Substrats (1) ein Metalldepot (2) aufgebracht ist und auf dem Metalldepot (2) ein Klebepunkt (3) angeordnet ist, und
wobei der Deckel (6) auf die Schale (5) aufgesetzt ist und mindestens einen Vorsprung (63) aufweist, der das Substrat (1) außerhalb des Klebepunkts (3) berührt und das Substrat (1) in einer Richtung senkrecht zur Oberfläche des Substrats (1) fixiert, wobei mindestens zwei Substrate als Stapel in die Schale (5) eingelegt sind, und wobei ein Abstandshalter (4) so zwischen die Substrate eingelegt ist, dass der Abstandshalter das Substrat (1) nur außerhalb des Klebepunkts (3) berührt,
wobei die Schale (5) und der Abstandshalter (4) dazu eingerichtet sind, dass der in vertikaler Richtung nach oben gerichteter Klebepunkt (3) nicht mit einer Innenseite des Deckels (6) oder einem daraufgelegten Substrat in Berührung kommt.

2. Verpackungseinheit (10) nach einem der vorherigen Ansprüche, wobei die Schale (5) einen Boden (51) und eine umlaufende Wand (52) umfasst, und wobei die umlaufende Wand (52) in Richtung des Bodens (51) eine geringere Außenabmessung aufweist als an ihrem freien Ende.

3. Verpackungseinheit (10) nach einem der vorherigen Ansprüche, wobei der Deckel (6) mindestens ein Zentrierelement (9) zum Befestigen des Deckels (6) auf der Schale (5) aufweist.

4. Verpackungseinheit (10) nach einem der vorherigen Ansprüche, wobei die Schale (5) und der Deckel (6) unterschiedlich geformt sind.

5. Verpackungseinheit (10) nach einem der vorherigen Ansprüche, wobei die Schale (5) und der Deckel (6) einstückig ausgebildet sind.

6. Verpackungseinheit (10) nach einem der vorherigen Ansprüche, wobei das Substrat (1) ein Metallkeramiksubstrat ist und eine Keramikschicht (11) und mindestens eine Metallisierungsschicht (12) umfasst, wobei das Metalldepot (2) auf die Metallisierungsschicht (12) aufgebracht ist.

7. Verpackungseinheit (10) nach einem der vorherigen Ansprüche, wobei der Klebepunkt (3) gestaltet ist, um ein elektronisches Bauteil auf dem Substrat (1) zu fixieren, und wobei der Klebepunkt (3) bei Raumtemperatur verschmierbar ist.

8. Verpackungseinheit (10) nach einem der vorherigen Ansprüche, wobei das Metalldepot (2) ein lötbares oder sinterbares Metall oder eine lötbare oder sinterbare Legierung umfasst.

9. Verpackungseinheit (10) nach einem der vorherigen Ansprüche, wobei das Substrat (1) eine Vielzahl von nebeneinander angeordneten Einzelsubstraten umfasst.

10. Verpackungseinheit (10) nach einem der vorherigen Ansprüche, wobei die Schale (5) ein Trockenmittel (8) zwischen dem Boden (51) der Schale (5) und dem Substrat (1) zur trockenen Aufbewahrung des Substrats (1) aufweist.

11. Ein Verpackungsstapel, umfassend eine Vielzahl von aufeinandergestapelten Verpackungseinheiten nach einem der vorherigen Ansprüche.

12. Verpackungsstapel nach dem vorherigen Anspruch, wobei zwischen den Verpackungseinheiten (10) ein Dämpfungselement (7) zum Abfedern eines Stoßes eingelegt ist.

13. Ein Verfahren zur Verpackung eines Substrats (1), umfassend die folgenden Schritte:
- Bereitstellen einer Schale (5),
- Einlegen eines Substrats (1) in die Schale (5), und
- Aufsetzen eines Deckels (6) auf die Schale (5),
wobei auf eine Oberfläche des Substrats (1) ein Metalldepot (2) aufgebracht ist und auf dem Metalldepot (2) ein Klebepunkt (3) angeordnet ist, und
wobei der Deckel (6) mindestens einen Vorsprung (63) aufweist, der das Substrat (1) außerhalb des Klebepunkts (3) berührt und das Substrat (1) in einer Richtung senkrecht zur Oberfläche des Substrats (1) fixiert,
- Einlegen eines Abstandshalters (4) auf das Substrat (1) in der Schale (5), und
- Einlegen eines weiteren Substrats (1') auf den Abstandshalter (4),
wobei der Abstandshalter (4) so zwischen die Substrate (1, 1') eingelegt ist, dass er das Substrat (1) nur außerhalb des Klebepunkts (3) berührt,
wobei die Schale (5) und der Abstandshalter (4) dazu eingerichtet sind, dass der in vertikaler Richtung nach oben gerichteter Klebepunkt (3) nicht mit einer Innenseite des Deckels (6) oder einem daraufgelegten Substrat in Berührung kommt.

## Claims

1. A packaging unit (10) for a substrate (1), comprising:
- a tray (5),
- a substrate (1), and
- a lid (6),
wherein the substrate (1) is placed in the tray (5),
wherein a metal deposit (2) is applied to a surface of the substrate (1), and an adhesive point (3) is arranged on the metal deposit (2), and
wherein the lid (6) is placed on the tray (5) and has at least one projection (63) which contacts the substrate (1) outside the adhesive point (3) and fixes the substrate (1) in a direction perpendicular to the surface of the substrate (1), wherein at least two substrates are placed as a stack in the tray (5), and wherein a spacer (4) is inserted between the substrates in such a way that the spacer contacts the substrate (1) only outside the adhesive point (3),
wherein the tray (5) and the spacer (4) are configured so that the adhesive point (3) that is directed upwards in the vertical direction does not come into contact with an inner side of the lid (6) or a substrate placed thereupon.

2. Packaging unit (10) according to one of the preceding claims, wherein the tray (5) comprises a bottom (51) and a circumferential wall (52), and wherein the circumferential wall (52) has a smaller outer dimension in the direction of the bottom (51) than at its free end.

3. Packaging unit (10) according to one of the preceding claims, wherein the lid (6) has at least one centering element (9) for attaching the lid (6) to the tray (5).

4. Packaging unit (10) according to one of the preceding claims, wherein the tray (5) and the lid (6) are shaped differently.

5. Packaging unit (10) according to one of the preceding claims, wherein the tray (5) and the lid (6) are formed in one piece.

6. Packaging unit (10) according to one of the preceding claims, wherein the substrate (1) is a metal-ceramic substrate and comprises a ceramic layer (11) and at least one metalization layer (12), wherein the metal deposit (2) is applied to the metalization layer (12).

7. Packaging unit (10) according to one of the preceding claims, wherein the adhesive point (3) is designed to affix an electronic component to the substrate (1), and wherein the adhesive point (3) can be smeared at room temperature.

8. Packaging unit (10) according to one of the preceding claims, wherein the metal deposit (2) comprises a solderable or sinterable metal or a solderable or sinterable alloy.

9. Packaging unit (10) according to one of the preceding claims, wherein the substrate (1) comprises a plurality of individual substrates arranged next to one another.

10. Packaging unit (10) according to one of the preceding claims, wherein, between the bottom (51) of the tray (5) and the substrate (1), the tray (5) has a desiccant (8) for the dry storage of the substrate (1).

11. Packaging stack comprising a plurality of packaging units according to one of the preceding claims stacked on top of each other.

12. Packaging stack according to the preceding claim, wherein a damping element (7) for cushioning an impact is inserted between the packaging units (10).

13. Method for packaging a substrate (1), comprising the following steps:
- providing a tray (5),
- placing a substrate (1) in the tray (5), and
- placing a lid (6) on the tray (5),
wherein a metal deposit (2) is applied to a surface of the substrate (1), and an adhesive point (3) is arranged on the metal deposit (2), and
wherein the lid (6) has at least one projection (63) which contacts the substrate (1) outside the adhesive point (3) and fixes the substrate (1) in a direction perpendicular to the surface of the substrate (1),
- placing a spacer (4) on the substrate (1) in the tray (5), and
- placing a further substrate (1') on the spacer (4),
wherein the spacer (4) is inserted between the substrates (1, 1') in such a way that it contacts the substrate (1) only outside the adhesive point (3),
wherein the tray (5) and the spacer (4) are configured so that the adhesive point (3) that is directed upwards in the vertical direction does not come into contact with an inner side of the lid (6) or a substrate placed thereupon.

## Revendications

1. Unité d'emballage (10) pour un substrat (1), comprenant :
- une barquette (5),
- un substrat (1) et
- un couvercle (6),
le substrat (1) étant introduit dans la barquette (5),
un dépôt métallique (2) étant appliqué sur une surface du substrat (1) et un point adhésif (3) étant disposé sur le dépôt métallique (2) et
le couvercle (6) étant placé sur la barquette (5) et présentant au moins une saillie (63), qui entre en contact avec le substrat (1) en dehors du point adhésif (3) et qui fixe le substrat (1) dans une direction perpendiculaire à la surface du substrat (1),
au moins deux substrats étant introduits en pile dans la barquette (5) et un élément d'écartement (4) étant introduit entre les substrats de telle sorte que l'élément d'écartement entre en contact avec le substrat (1) uniquement en dehors du point adhésif (3),
la barquette (5) et l'élément d'écartement (4) étant conçus de telle manière que le point adhésif (3) orienté vers le haut dans la direction verticale ne vient pas en contact avec un côté intérieur du couvercle (6) ou un substrat posé sur celui-ci.

2. Unité d'emballage (10) selon l'une quelconque des revendications précédentes, dans laquelle la barquette (5) comprend un fond (51) et une paroi périphérique (52) et dans laquelle la paroi périphérique (52) présente, en direction du fond (51), une dimension extérieure inférieure à celle à son extrémité libre.

3. Unité d'emballage (10) selon l'une quelconque des revendications précédentes, dans laquelle le couvercle (6) présente au moins un élément de centrage (9) pour fixer le couvercle (6) sur la barquette (5).

4. Unité d'emballage (10) selon l'une quelconque des revendications précédentes, dans laquelle la barquette (5) et le couvercle (6) sont de formes différentes.

5. Unité d'emballage (10) selon l'une quelconque des revendications précédentes, dans laquelle la barquette (5) et le couvercle (6) sont réalisés d'un seul tenant.

6. Unité d'emballage (10) selon l'une quelconque des revendications précédentes, dans laquelle le substrat (1) est un substrat métallo-céramique et comprend une couche de céramique (11) et au moins une couche de métallisation (12), le dépôt métallique (2) étant appliqué sur la couche de métallisation (12).

7. Unité d'emballage (10) selon l'une quelconque des revendications précédentes, dans laquelle le point adhésif (3) est conçu pour fixer un composant électronique sur le substrat (1) et dans laquelle le point adhésif (3) peut s'étaler à température ambiante.

8. Unité d'emballage (10) selon l'une quelconque des revendications précédentes, dans laquelle le dépôt métallique (2) comprend un métal apte à être soudé ou fritté ou un alliage apte à être soudé ou fritté.

9. Unité d'emballage (10) selon l'une quelconque des revendications précédentes, dans laquelle le substrat (1) comprend une pluralité de substrats individuels disposés les uns à côté des autres.

10. Unité d'emballage (10) selon l'une quelconque des revendications précédentes, dans laquelle la barquette (5) présente un agent desséchant (8) entre le fond (51) de la barquette (5) et le substrat (1) pour la conservation au sec du substrat (1).

11. Pile d'emballage, comprenant une pluralité d'unités d'emballage selon l'une quelconque des revendications précédentes, empilées les unes sur les autres.

12. Pile d'emballage selon la revendication précédente, dans laquelle un élément d'amortissement (7) est introduit entre les unités d'emballage (10) pour amortir un choc.

13. Procédé d'emballage d'un substrat (1), comprenant les étapes suivantes :
- mise à disposition d'une barquette (5),
- introduction d'un substrat (1) dans la barquette (5) et
- placement d'un couvercle (6) sur la barquette (5),
un dépôt métallique (2) étant appliqué sur une surface du substrat (1) et un point adhésif (3) étant disposé sur le dépôt métallique (2) et
le couvercle (6) présentant au moins une saillie (63), qui entre en contact avec le substrat (1) en dehors du point adhésif (3) et qui fixe le substrat (1) dans une direction perpendiculaire à la surface du substrat (1),
- introduction d'un élément d'écartement (4) sur le substrat (1) dans la barquette (5) et
- introduction d'un autre substrat (1') sur l'élément d'écartement (4),
l'élément d'écartement (4) étant introduit entre les substrats (1, 1') de telle sorte qu'il entre en contact avec le substrat (1) uniquement en dehors du point adhésif (3),
la barquette (5) et l'élément d'écartement (4) étant conçus de telle manière que le point adhésif (3) orienté vers le haut dans la direction verticale ne vient pas en contact avec un côté intérieur du couvercle (6) ou un substrat posé sur celui-ci.
